(19) Europäisches Patentamt / European Patent Office / Office européen des brevets

(11) **EP 4 105 669 B1**

(12) **EUROPEAN PATENT SPECIFICATION**

(45) Date of publication and mention
of the grant of the patent:
**16.04.2025 Bulletin 2025/16**

(21) Application number: **21877880.1**

(22) Date of filing: **16.09.2021**

(51) International Patent Classification (IPC):
$G01R\ 31/36^{(2020.01)}$    $G01R\ 31/392^{(2019.01)}$
$G01R\ 31/367^{(2019.01)}$    $G01R\ 31/396^{(2019.01)}$
$H01M\ 10/48^{(2006.01)}$    $B60L\ 58/16^{(2019.01)}$
$B60L\ 58/26^{(2019.01)}$    $H01M\ 10/42^{(2006.01)}$
$H01M\ 10/613^{(2014.01)}$    $H01M\ 10/625^{(2014.01)}$

(52) Cooperative Patent Classification (CPC):
**B60L 58/16; B60L 58/26; G01R 31/392;**
**H01M 10/42; H01M 10/48; H01M 10/486;**
**H01M 10/613; H01M 10/625;** B60L 2240/545;
B60L 2240/547; B60L 2240/549; B60L 2240/80;
B60L 2260/26; G01R 31/367; G01R 31/374;
(Cont.)

(86) International application number:
**PCT/KR2021/012731**

(87) International publication number:
**WO 2022/075628 (14.04.2022 Gazette 2022/15)**

(54) **METHOD AND APPARATUS FOR CALCULATING AGING DEGREE OF BATTERY**
VERFAHREN UND VORRICHTUNG ZUR BERECHNUNG DES BATTERIEABBAUGRADES
PROCÉDÉ ET APPAREIL DE CALCUL DU DEGRÉ DE DÉGRADATION D'UNE BATTERIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **08.10.2020 KR 20200130580**

(43) Date of publication of application:
**21.12.2022 Bulletin 2022/51**

(73) Proprietor: **LG Energy Solution, Ltd.**
**Seoul 07335 (KR)**

(72) Inventor: **YUN, Seong Jun**
**Daejeon 34122 (KR)**

(74) Representative: **Plasseraud IP**
**104 Rue de Richelieu**
**CS92104**
**75080 Paris Cedex 02 (FR)**

(56) References cited:
JP-A- 2008 309 651    JP-A- 2016 139 484
JP-A- 2017 020 923    JP-B2- 6 326 745
KR-B1- 101 839 141    US-A1- 2013 033 102
US-A1- 2015 067 379    US-A1- 2016 377 686

(52) Cooperative Patent Classification (CPC): (Cont.)
G01R 31/389; H01M 2010/4271; H01M 2220/20;
Y02E 60/10; Y02T 10/70

**Description**

**[Technical Field]**

CROSS-REFERENCE TO RELATED APPLICATION

This application claims priority to and the benefit of Korean Patent Application No. 10-2020-0130580 filed in the Korean Intellectual Property Office on October 8, 2020.

TECHNICAL FIELD

The present disclosure relates to a method and apparatus for calculating an aging degree of a battery.

**[Background Art]**

Recently, with the spread of electronic devices such as smart phones and the development of electric vehicles, research on secondary batteries as power supply sources has also been actively conducted. The secondary battery is provided in the form of a battery pack including a battery module in which a plurality of battery cells are connected in series and/or in parallel, and a battery management system (BMS) that manages an operation of the battery module.

The battery pack is continuously monitored in terms of an aging degree (an aging state) to ensure that it provides normal performance. The aging degree of the battery pack is estimated based on an internal resistance of a battery cell included in the battery pack, and the internal resistance of the battery cell is highly dependent on temperature. Thus, to accurately estimate the aging degree of the battery pack, accurate measurement of the temperature of the battery cell is required.

US 2016/377686 A1 discloses a method for calculating an ageing degree of a battery. A duration in a non-operational state of a battery is determined and an average temperature is calculated during said duration and based on the calculated temperature, the degradation of the battery is calculated.

**[Disclosure]**

**[Technical Problem]**

The present disclosure has been made to solve such problems, and provides a method and apparatus for calculating an aging degree in which an appropriate temperature of a battery cell for accurately estimating an aging degree of a battery pack may be calculated to estimate an accurate internal resistance of the battery cell and an accurate aging degree of a battery may be calculated based on the accurate internal resistance.

**[Technical Solution]**

To solve the foregoing technical problems, according to an aspect of embodiments of the present disclosure, there is provided a method of calculating an aging degree of a battery, the method including obtaining a duration of the battery in a first state, when a use state of the battery is changed from the first state to a second state, determining whether the obtained duration is greater than or equal to a first reference time, calculating an average temperature of the battery based on a first algorithm when the duration is less than the first reference time, and calculating the average temperature of the battery based on a second algorithm when the duration is greater than or equal to a reference time, and calculating the aging degree of the battery based on the calculated average temperature.

According to another feature of an embodiment of the present disclosure, the first algorithm may calculate the average temperature value of the battery by using the minimum temperature of the battery calculated before start of the first state of the battery and a temperature measurement value of a temperature sensor mounted on the battery.

According to another feature of an embodiment of the present disclosure, the second algorithm may calculate the minimum temperature value of the battery based on a temperature measurement value of a first temperature sensor mounted on the battery and a temperature measurement value of a second temperature sensor mounted on a cooling means of the battery, and calculate the average temperature of the battery using the temperature measurement value of the first temperature sensor and the calculated minimum temperature value.

According to another feature of an embodiment of the present disclosure, the second algorithm may calculate the minimum temperature value using a value indicating a relationship between a maximum temperature value and the minimum temperature value of the battery, the maximum temperature value and the minimum temperature value being calculated and stored before the start of the first state of the battery.

According to another feature of an embodiment of the present disclosure, the first temperature sensor may include a sensor arranged in a maximum-temperature region of the battery.

According to another feature of an embodiment of the present disclosure, the minimum temperature value of the battery may include a temperature value of a region where the battery is adjacent to the cooling means.

According to another feature of an embodiment of the present disclosure, the first algorithm and the second algorithm are used for initial value setting when the state of the battery is changed to the second state.

According to another feature of an embodiment of the present disclosure, when the state of the battery is the second state, the minimum temperature value of the battery is calculated based on a heat transfer model among a first position of the first temperature sensor mounted on the battery, a second position of the second temperature sensor mounted on the cooling means of the battery, and a third position of the battery where the battery and the cooling means contact each other.

According to another feature of an embodiment of the present disclosure, least one of a space between the first position and the third position and a space between the third position and the second position by using a RC model.

According to another feature of an embodiment of the present disclosure, when the duration is a second reference time longer than the first reference time, an average temperature is calculated by the third algorithm in place of the second algorithm, and the third algorithm uses the temperature measurement value of the first temperature sensor mounted on the battery, as the average temperature.

According to another feature of an embodiment of the present disclosure, the first state may include a parking state of an electric vehicle and the second state may include a driving state of the electric vehicle.

According to another feature of an embodiment of the present disclosure, the first state may include a state in which the battery is used as an output less than a reference output, and the second state may include a state in which the battery is used as an output greater than or equal to the reference output.

To solve the foregoing technical problems, according to another aspect of embodiments of the present disclosure, there is provided an apparatus for calculating an aging degree of a battery, the apparatus including a time comparing unit determining whether a duration of a first state is greater than or equal to a first reference time, when a use state of the battery is changed from the first state to a second state, an average temperature calculating unit calculating an average temperature of the battery based on a first algorithm when the duration is less than the first reference time, and calculating the average temperature of the battery based on a second algorithm when the duration is greater than or equal to a reference time, and an aging degree calculating unit calculating the aging degree of the battery based on the calculated average temperature.

According to another feature of an embodiment of the present disclosure, the first algorithm may calculate the average temperature value of the battery by using the minimum temperature of the battery calculated before start of the first state of the battery and a temperature measurement value of the temperature sensor mounted on the battery.

According to another feature of an embodiment of the present disclosure, the second algorithm may calculate the minimum tempeature value of the battery based on a temperature measurement value of a first temperature sensor mounted on the battery and a temperature measurement value of a second temperature sensor mounted on a cooling means of the battery, and calculate the average temperature of the battery using the temperature measurement value of the first temperature sensor and the calculated minimum temperature value.

[Advantageous Effects]

With a structure described above, an appropriate temperature of a battery cell for accurately estimating an aging degree of a battery pack may be calculated to estimate an accurate internal resistance of the battery cell, and an accurate aging degree of a battery may be calculated based on the accurate internal resistance .

[Description of Drawings]

FIG. 1 schematically illustrates a structure of a battery pack according to an embodiment of the present disclosure.
FIG. 2 is a block diagram showing a functional configuration of a battery management system according to an embodiment of the present disclosure.
FIG. 3 schematically illustrates a method of calculating an aging degree, according to an embodiment of the present disclosure.
FIG. 4 conceptually illustrates heat transfer inside a battery module.
FIG. 5 is a schematic diagram for describing heat transfer modeling.
FIG. 6 is a graph for describing a temperature change calculated by a heat transfer model.
FIG. 7 illustrates a RC heat transfer model according to an embodiment of the present disclosure.

FIG. 8 illustrates parameters used by a method of calculating an aging degree, according to an embodiment of the present disclosure.

FIG. 9 illustrates an aging degree calculated according to an embodiment of the present disclosure.

FIGS. 10A through 10C illustrate an RC heat transfer model according to an embodiment of the present disclosure.

FIG. 11 is a flowchart illustrating a method of calculating an aging degree, according to an embodiment of the present disclosure.

FIG. 12 is a flowchart illustrating a method of calculating an aging degree, according to another embodiment of the present disclosure.

FIG. 13 shows a hardware configuration of a battery management system according to embodiments of the present disclosure.

**[Mode for Invention]**

Hereinafter, various embodiments of the present disclosure will be described in detail with reference to the accompanying drawings. In this document, identical reference numerals will be used for identical components in the drawings, and the identical components will not be redundantly described.

For various embodiments of the present disclosure disclosed in this document, specific structural or functional descriptions are only exemplified for the purpose of describing the embodiments of the present disclosure, and various embodiments of the present disclosure may be implemented in various forms, and should not be construed as being limited to the embodiments described in this document.

As used in various embodiments, the terms "1st", "2nd", "first", "second", or the like may modify various components regardless of importance, and do not limit the components. For example, a first component may be named as a second component without departing from the right scope of the present disclosure, and similarly, the second component may be named as the first component.

Terms used in the present document are used for only describing a specific exemplary embodiment of the disclosure and may not have an intention to limit the scope of other exemplary embodiments of the disclosure. It is to be understood that the singular forms include plural references unless the context clearly dictates otherwise.

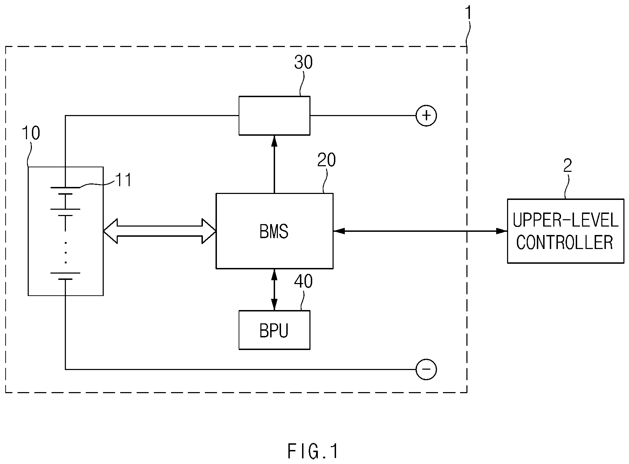

FIG. 1 illustrates a structure of a battery pack 1 according to an embodiment of the disclosure.

Referring to FIG. 1, the battery pack 1 may include a battery module 10 that includes one or more battery cells 11 and is chargeable/dischargeable, a switching unit 30 serially connected to a positive (+) terminal side or a negative (-) terminal side of the battery module 10 to control a charging/discharging current flow of the battery module 10, and a battery management system (BMS) 20 for control and management to prevent over-charging and over-discharging by monitoring voltage, current, temperature, etc., of the battery cell 11 and/or the battery module 10. The battery pack 1 may further include a battery protection unit (BPU) 40.

The battery module 10 may include the one or more battery cells 11 that are chargeable and dischargeable. In the battery module 10, the plurality of battery cells 11 may be connected in series and/or in parallel to each other according to required specifications of the battery pack 1. That is, the number of battery cells 11 and the form of connection therebetween may be determined according to a required output (voltage, current, etc.) of the battery pack 1. An output voltage of the battery module 10 may be supplied as a pack voltage to an outside through a PACK (+) terminal and a PACK (-) terminal, which are output terminals. The battery cell 11 may be a lithium ion (Li-ion) battery, an Li-ion polymer battery, a nickel-cadmium (Ni-Cd) battery, a nickel hydrogen (Ni-MH) battery, etc., and may not be limited thereto when the battery cell 11 is a chargeable battery.

The BMS 20 may control and manage an overall operation of the battery pack 1. The BMS 20 may control an operation of the switching unit 30 to control a charging/discharging operation of the battery module 10. In addition, the BMS 20 may monitor a voltage, a current, a temperature, etc., of the battery module 10 and/or each battery cell included in the battery module 10. A sensor or various measurement modules for monitoring performed by the BMS 20, not shown, may be additionally installed in a random position of the battery module 10, a charging/discharging path, or the battery pack 1, etc. The BMS 20 may calculate a parameter indicating a state of the battery module 10, e.g., SOC or SOH, etc., based on a measurement value such as monitored voltage, current, temperature, etc. That is, the BMS 20 may function as a voltage measuring unit 21, a current measuring unit 22, and a control unit 23 described below. That is, the BMS 20 may function as a voltage measuring unit 21, a current measuring unit 22, a temperature measuring unit 23, a storing unit 24, and a control unit 25.

The BMS 20 may include various components such as a memory that stores a computer program that is a command for control and management of an overall operation of the battery pack 1, a micom that executes a program and controls an overall operation of the BMS 20 as a controller, an input/output device such as a sensor, a measurement means, etc., and other peripheral circuits, and so forth. Additionally, the BMS 20 may include a circuit configuration for monitoring a voltage, a current, a temperature, etc., of the battery cell as described above.

The switching unit 30 may be a component for controlling a current flow for charging or discharging of the battery module 10. As the switching unit 30, a semiconductor switching element such as a relay, a MOSTET, etc., may be used. An on/off operation of the switching unit 30 may be controlled by the BMS 20.

The battery pack 1 may be communicatively connected to an external upper-level controller 2. That is, the BMS 20 may transmit various data regarding the battery pack 1 to the upper-level controller 2. The BMS 20 may receive a control signal regarding an operation of the battery pack 1 from the upper-level controller 2. The BMS 20 may receive, from the upper-level controller 2, a signal indicating a state of a load that is a device having the battery pack 1 mounted thereon. The upper-level controller 2 may be a control system provided in the load. The load may be any device in which the battery pack 1 is mounted, such as an electric vehicle, an electric bicycle, etc., to operate by using power supplied by the battery pack 1. When the battery pack 1 is mounted in the electric vehicle, the upper-level controller 2 may be a vehicle controller for controlling driving of the vehicle.

The BPU 40 may include components for a stable operation of the battery pack 1. The BPU 40 may include a cooling means for regulating a temperature in the battery pack 1. As the cooling means, any method such as water cooling using cooling water, air cooling using a cooling fan, etc., may be used. The BPU 40 may also include a fuse for blocking a current path when an overcurrent is generated due to occurrence of a short-circuit or the like.

The BMS 20 according to the present disclosure may calculate an appropriate average temperature of the battery pack 1 from a temperature of the specific battery cell 11 to calculate an accurate aging degree of the battery pack 1. The BMS 20 may calculate the average temperature by using a maximum temperature and a minimum temperature of the battery pack 1. The average temperature may be calculated by an algorithm determined according to the state of the battery pack 1. Hereinbelow, a detailed method of calculating an aging degree of a battery in the battery pack 1 according to the present disclosure will be described. Herein, when the aging degree of the battery is calculated, it may mean that the aging degree of the battery cell 11 is calculated. Alternatively, when the aging degree of the battery is calculated, it may mean that the aging degree of the battery module 10 or the battery pack 1 is calculated.

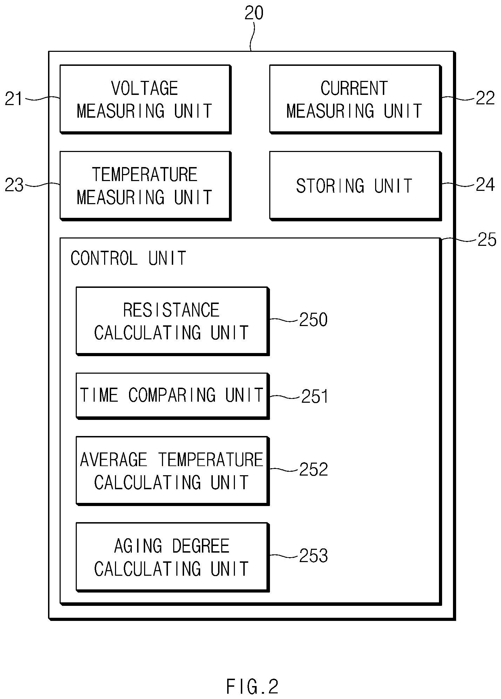

FIG. 2 is a block diagram showing a functional configuration of the BMS 20 according to an embodiment of the present disclosure.

Referring to FIG. 2, the BMS 20 may include the voltage measuring unit 21, the current measuring unit 22, the temperature measuring unit 23, the storing unit 24, and the control unit 25.

The voltage measuring unit 21 may be configured to measure a voltage of the battery module 10 and/or the battery cell 11. In addition, the voltage measuring unit 21 may measure an open circuit voltage (OCV) of the battery cell 11. The voltage measuring unit 21 may provide the measured voltage of the battery cell 11, the measured OCV of the battery cell 11, etc., to the control unit 25. The voltage of the battery cell 11 may be a discharging voltage or a charging voltage, which is a voltage when a current flows through the battery cell 11. The OCV of the battery cell 11 may be a voltage corresponding to a case where a current does not flow through the battery cell 11. The voltage measuring unit 21 may store the measured voltage of the battery cell 11, the measured OCV of the battery cell 11, etc., to the storing unit 24. The voltage measuring unit may be configured to measure a voltage of each of the plurality of battery cells 11.

The current measuring unit 22 may be configured to measure current output from the battery cell 11. The current measuring unit 22 may further include a current sensor provided on a main current path output from the battery module 10 to the load. The current measuring unit 22 may provide the measured current of the battery cell 11 to the control unit 25. In addition, the current measuring unit 22 may store the measured current of the battery cell 11 in the storing unit 24. While the current measuring unit 22 is described as measuring a current of the battery cell 11, the current measuring unit 22 may also be implemented as measuring the current of the battery module 10. The current measuring unit 22 may be configured to measure current for each of the plurality of battery cells 11.

The temperature measuring unit 23 may be configured to measure a temperature of the battery module 10 and/or the battery cell 11. The temperature measuring unit 23 may measure a temperature of a position where a temperature is expected to be at least maximum among a plurality of positions in the battery module 10. Alternatively, the temperature measuring unit 23 may measure a temperature of each of the plurality of positions in the battery module 10. The temperature measuring unit 23 may further include a temperature sensor provided in a position where a temperature is to be measured.

The temperature measuring unit 23 may be configured to measure a temperature of a predetermined position of a cooling means operating as the BPU 40. The temperature measuring unit 23 may measure a temperature of a position where a temperature is expected to be minimum in the cooling means. For example, the position where the temperature is expected to be minimum may be a position where cooling water is introduced. Alternatively, the position where the temperature is expected to be minimum may be a position where the cooling fan is mounted and thus the cooling wind is introduced.

The storing unit 24 may store various computer programs required for an operation of the control unit 25. The storing unit 24 may store an equation, an algorithm, etc., required for operations of a resistance calculating unit 250, a time comparing unit 251, an average temperature calculating unit 252, and an aging degree calculating unit 253 described later. That is, the storing unit 24 may store various computer programs required for calculating the aging degree of the battery.

The storing unit 24 may store various data generated by an operation of the control unit 25. For example, data regarding a voltage measured by the voltage measuring unit 21, data regarding a current measured by the current measuring unit 22, data regarding a temperature measured by the temperature measuring unit 23, various data calculated by the control unit 25 through an operation, etc., may be stored in the storing unit 24.

The storage 24 may also store a reference resistance table. The reference resistance table may be a table in which a temperature of a battery and a beginning of life (BOL) internal resistance of the battery are mapped to each other. That is, by using a table, when a temperature is specified, a BOL internal resistance of the battery at the temperature may be obtained.

The control unit 25 may control operations of the voltage measuring unit 21, the current measuring unit 22, the temperature measuring unit 23, and the storing unit 24. The control unit 25 may calculate measurement results of the voltage measuring unit 21, the current measuring unit 22, and the temperature measuring unit 23 and calculate an aging degree of the battery based on data obtained from the storing unit 24. That is, the control unit 25 may perform a function as an apparatus for calculating an aging degree of a battery. The control unit 25 may include the resistance calculating unit 250, the time comparing unit 251, the average temperature calculating unit 252, and the aging degree calculating unit 253.

The resistance calculating unit 250 may be configured to calculate a current internal resistance of the battery. That is, the resistance calculating unit 250 may calculate a parameter indicating a current aging state of the battery. To calculate the internal resistance, the resistance calculating unit 250 may receive, as an input, a voltage of the battery cell 11 measured by the voltage measuring unit 21, the OCV of the battery cell 11, and the current measured by the current measuring unit 22. The resistance calculating unit 250 may use a voltage of the battery cell 11, an OCV of the battery cell 11, and a current of the battery cell 11 at a specific point in time. Alternatively, the resistance calculating unit 250 may use an average value of a voltage of the battery cell 11 measured for a predetermined period, an average value of an OCV of the battery cell 11 measured for the predetermined period, and an average value of a current of the battery cell 11 measured for the predetermined period. In this case, the resistance calculating unit 250 may be configured to calculate an average value based on received values and to receive an already calculated average value.

The resistance calculating unit 250 may also calculate a current internal resistance, further considering a temperature value measured by the temperature measuring unit 23.

The time comparing unit 251 may compare a duration in which a use state of the battery maintains a first state (hereinafter, simply referred to as a 'duration') with a first reference time. To this end, a duration of each state of the battery may be counted by a timer (not shown). The time comparing unit 251 may obtain a duration in the first state of the battery and compare the obtained duration with the first reference time when the use state of the battery changes from the first state to a second state. The time comparing unit 251 may determine whether the duration is greater than or equal to the first reference time based on the comparison. Herein, the first state may be a parking state of an electric vehicle and the second state may be a driving state of the electric vehicle. Alternatively, the first state may be a state in which the battery is used as an output less than a reference output, and the second state may be a state in which the battery is used as an output greater than or equal to the reference output.

Meanwhile, the control unit 25 may receive data regarding a state of a load from the upper-level controller 2. Alternatively, the state of the battery pack 1 may be determined by monitoring the output of the battery pack 1. The time comparing unit 251 may obtain a duration for states of the battery based on identifying a state of the battery by using the above-described method.

The average temperature calculating unit 252 may determine an algorithm for calculating an average temperature based on a comparison result of the time comparing unit 251. Although it has been described that the time comparing unit 251 determines whether the duration time is greater than the first reference time, the average temperature calculating unit 252 may also perform this operation.

The average temperature calculating unit 252 may calculate the average temperature of the battery based on a first algorithm when the duration is less than the first reference time. The first algorithm is a scheme to calculate the average temperature value of the battery by using the minimum temperature of the battery calculated before start of the first state of the battery and a temperature measurement value of the temperature sensor mounted on the battery. Herein, the temperature sensor mounted on the battery may be a sensor arranged in a maximum-temperature region of the battery. Alternatively, the temperature sensor mounted on the battery may be a sensor arranged in a region estimated as the maximum-temperature region of the battery.

The average temperature calculating unit 252 may calculate the average temperature of the battery based on a second algorithm when the duration is greater than or equal to the reference time. The second algorithm may calculate the minimum temperature value of the battery (herein, the minimum temperature value of the battery may be a temperature value of a region in which the battery is adjacent to the cooling means) based on the temperature measurement value of the first temperature sensor mounted on the battery and the temperature measurement value of the second temperature sensor mounted on the cooling means of the battery. In this case, the minimum temperature value may be calculated using a value (a proportional coefficient) indicating a relationship between the maximum temperature value and the minimum temperature value, calculated before start of the first state and stored, of the battery. Thereafter, the average temperature of the battery may be calculated using the temperature measurement value of the first temperature sensor and the calculated minimum temperature value.

The average temperature calculating unit 252 may calculate the average temperature of the battery using the first algorithm or the second algorithm, and set an initial average temperature used when the battery is changed from the first state to the second state. That is, the first algorithm and the second algorithm may be used for initial value setting at the time when the state of the battery is changed into the second state.

The aging degree calculating unit 253 may calculate the aging degree of the battery based on the average temperature calculated by the average temperature calculating unit 252. The aging degree calculating unit 253 may calculate the aging degree based on an initial internal resistance and a current internal resistance. For example, the aging degree calculating unit 235 may calculate the aging degree based on the amount of change of the current internal resistance with respect to the initial internal resistance. More specifically, the aging degree may be calculated by [Equation 1].

$$[\text{Equation } 1]$$

$$SOHR[\%] = 100 - [\frac{Resistance\ current - Resistance\ BOL}{Resistance\ BOL}] \times 100$$

A state of health resistance (SOHR), Resistance_current, and Resistance_BOL may indicate an aging degree, a current internal resistance, and an initial internal resistance, respectively.

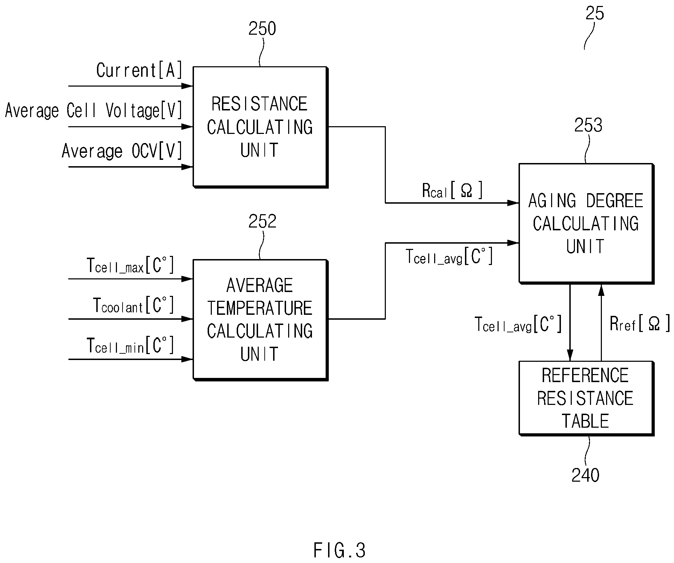

FIG. 3 schematically illustrates a method of calculating an aging degree, according to an embodiment of the present disclosure.

The resistance calculating unit 250 may receive, as inputs, a voltage of the battery cell 11 measured by the voltage measuring unit 21, the OCV of the battery cell 11, and the current measured by the current measuring unit 22. The voltage input to the resistance calculating unit 250 may be an average cell voltage that is an average voltage of the battery cell 11. The OCV input to the resistance calculating unit 250 may be an average value of OCVs of the battery cell 11. The resistance calculating unit 250 may calculate a current internal resistance $R_{cal}$ based on the input voltage, OCV, and current. The resistance calculating unit 250 may calculate the current internal resistance further based on the temperature of the battery cell 11. As a method of calculating the internal resistance, various well-known methods may be used. For example, the internal resistance may be calculated by estimating a resistance value of an equivalent circuit model (ECM) through a recursive least square method. However, such a method of calculating the internal resistance may be merely an example and may not be limited thereto.

A maximum temperature value $T_{cell\_max}$ and a minimum temperature value $T_{cell\_min}$ of the battery cell 11, and a temperature value $T_{coolant}$ in the cooling means may be input to the average temperature calculating unit 252. The average temperature calculating unit 252 may calculate an average temperature $T_{cell\_avg}$ through the first algorithm or the second algorithm by using the foregoing input values based on a comparison result of the time comparing unit 251. The calculated average temperature may be set to the initial average temperature value in the second state when the state is changed from the first state to the second state.

$R_{cal}$ that is the current internal resistance value calculated by the resistance calculating unit 250 may be input to the aging degree calculating unit 253. $T_{cell\_avg}$ that is the average temperature value calculated by the average temperature calculating unit 252 may be input to the aging degree calculating unit 253. The aging degree calculating unit 253 may search for and obtain an initial internal resistance $R_{ref}$ of the battery at a corresponding temperature from a reference resistance table 240 by using $T_{cell\_avg}$ that is the average temperature value. Finally, the aging degree calculating unit 253 may calculate the aging degree based on the current internal resistance $R_{cal}$ and the reference internal resistance $R_{ref}$.

In the present disclosure, it is described that the control unit 25 corresponds to an apparatus for calculating an aging degree of a battery, but the present disclosure is not limited thereto. For example, a component further including at least some of the voltage measuring unit 21, the current measuring unit 22, the temperature measuring unit 23, and the storing unit 24 may be understood as corresponding to the apparatus for calculating the aging degree of the battery.

In the method of calculating the aging degree, conventionally, the reference internal resistance has been calculated using a measurement value of a specific temperature sensor in the battery without any change thereto. As a result, the accurate lifespan of the battery may not be determined because the inaccurate aging degree is calculated. Also, conventionally, the accurate aging degree may not be calculated in a sense that the aging degree of the battery is calculated regardless of the state of the battery.

However, in calculating the average temperature of the battery as described above, the apparatus for calculating the aging degree of the battery according to the present disclosure, when the state of the battery is changed from the first state to the second state, according to the duration in the first state, a different algorithm for calculating the average temperature of the battery is used. In addition, the apparatus for calculating the aging degree of the battery according to the present disclosure may calculate the minimum temperature of the battery by using an RC heat transfer model to calculate the average temperature of the battery, thereby accurately measuring the appropriate average temperature of the battery for calculating the aging degree.

Hereinbelow, the method of calculating the minimum temperature of the battery will be described in detail.

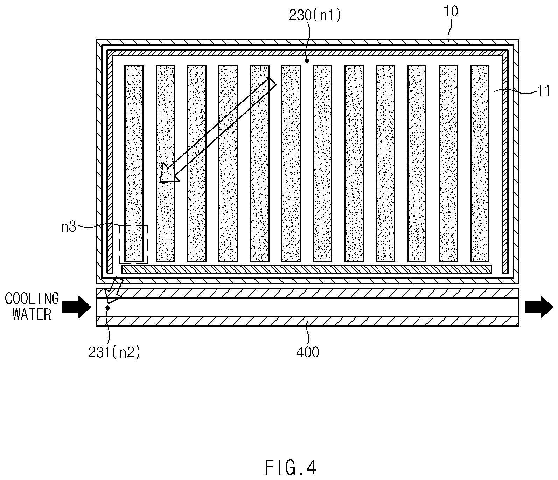

FIG. 4 conceptually illustrates heat transfer inside the battery module 10.

Referring to FIG. 4, a first temperature sensor 230 may be provided at a first position in an upper end of the battery module 10. The first position may be a position where the temperature is expected to be maximum in the battery module 10. The first temperature sensor 230 may be arranged in the maximum-temperature region of the battery module 10. In a side of the battery module 10, a cooling means 400 for cooling the battery module 10 may be provided. The cooling means 400 may be a cooling device of a water-cooling type, and overheating of the battery module 10 may be prevented as the cooling water flows through a flow path. A second temperature sensor 231 may be provided at a second position where the cooling water is introduced in the cooling means 400. The second position may be a position where the temperature is expected to be minimum in the battery pack 1. The second temperature sensor 231 may be arranged in the minimum-temperature region of the battery pack 1.

Assuming such an inner side of the battery pack 1, heat transfer may occur from the first position of the battery module 10 to a third position corresponding to a region where the battery module 10 and the cooling means 400 are adjacent to each other, and thereafter, heat transfer may occur from the third position to the second position of the cooling means 400. The third position may be a position where the temperature is expected to be minimum in the battery module 10. Herein, the first position may be indicated as a first node n1, the second position as a second node n2, and the third position as a third node n3.

Heat transfer from the first node n1 to the second node n2 and heat transfer from the second node n2 to the third node n3 may be interpreted as heat transfer between two solid bodies contacting each other. Heat transfer between solid bodies may be described as below.

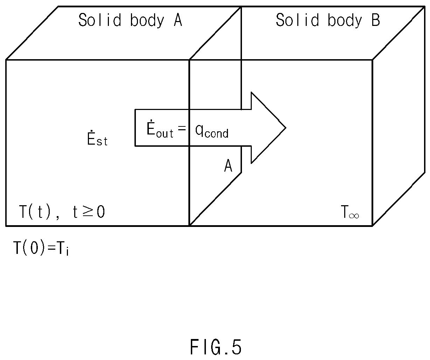

FIG. 5 is a schematic diagram for describing heat transfer modeling. Referring to FIG. 5, it may be assumed that a temperature of a solid body B is constant ($T^\infty$), and heat transfer may occur on a contact surface A with a solid body A. A relationship between a change rate $E_{in}$ of internal energy of the solid body A and a surface heat transfer rate $E_{out}$ may be expressed as below.

[Equation 2]

$$-\dot{E}_{out} = \dot{E}_{st}$$

or

[Equation 3]

$$-\frac{kA}{L}(T - T_\infty) = \rho V c \frac{dT}{dt}$$

Herein, k may indicate a thermal conductivity (W/m·k), L may indicate a distance (m) between two solid bodies (centers), and $\rho$, V, and c may indicate a density (kg/m$^3$), a volume (m$^3$), and a specific heat (J/kg·K) of the solid body A, respectively.

A temperature difference provided in [Equation 3] may be defined as [Equation 4] provided below.

[Equation 4]

$$\theta = T - T_\infty$$

In the case of ($d\theta/dt$) = ($dT/dt$) and constant $T^\infty$, [Equation 4] may be expressed as [Equation 5].

[Equation 5]

$$\frac{\rho V c}{kA/L}\frac{d\theta}{dt}=-\theta$$

[Equation 6] may be obtained by separating variables in [Equation 5] and integrating with respect to an initial condition T(0) = T_i for time t = 0.

[Equation 6]

$$\frac{\rho V c}{kA/L}\int_{\theta_i}^{\theta}\frac{d\theta}{\theta}=-\int_0^t dt$$

Herein, [Equation 7] or [Equation 8] may be obtained by $\theta_i = T_i - T_\infty$ and performing integration.

[Equation 7]

$$\frac{\rho V c}{kA/L}\ln\frac{\theta_i}{\theta}=t$$

[Equation 8]

$$\frac{\theta}{\theta_i}=\frac{T-T_\infty}{T_i-T_\infty}=\exp\left[-\frac{t}{(1/(kA/L))(\rho V c)}\right]$$

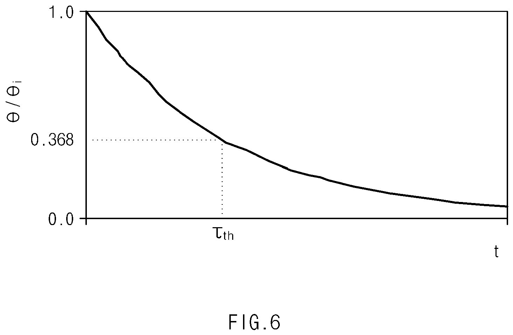

By using [Equation 7], a time required for a solid body to reach a certain temperature T may be obtained. Conversely, by using [Equation 8], a temperature reached by a solid body at a certain time t can be calculated. From [Equation 8], as the time t approaches infinity, a temperature difference Θ between the solid body A and the solid body B maintaining a constant temperature may decrease exponentially and thus become 0. That is, as the time t approaches infinity, the temperature of the solid body A may approach the temperature $T_\infty$ of the solid body B. The corresponding behavior is shown in FIG. 6.

FIG. 6 is a graph for describing a temperature change calculated by a heat transfer model. FIG. 6 shows a transient temperature response of the solid body A with respect to a thermal time constant.

From [Equation 8], $(1/(kA/L))(\rho V c)$ may be interpreted as a thermal time constant and may be expressed as below.

[Equation 9]

$$\tau_{th}=\left(\frac{1}{(kA/L)}\right)(\rho V c)=R_{th}C_{th}$$

$R_{th}$ may indicate a thermally conductive resistance, and $C_{th}$ may indicate a lumped thermal capacitance of the solid body A. An increase in $R_{th}$ or $C_{th}$ may mean that a solid body slowly reacts to a change in a thermal environment. Such a phenomenon may be very similar to a voltage reduction occurring when a capacitor is discharged through a resistor in an electrical RC circuit.

By applying a solid heat transfer model based on the foregoing heat transfer principle to a battery module (or a battery pack), the temperature of the battery cell may be calculated.

Referring back to FIG. 4, a description will be made continuously.

A region expected to have the minimum temperature in the battery module 10 may be a lower end portion (a region indicated by a dotted line) (the third node n3) of the lower end of the outermost battery cell 11 in the battery module 10. As indicated by an arrow, a heat transfer path may be simplified from the first node n1 to the third node n3 and from the third node n3 to the second node n2. Then, heat transfer between the first node n1 and the third node n3 may be interpreted as heat transfer between two solid bodies. That is, the two solid bodies may be a virtual solid body indicating a temperature value of the battery module 10 and the lower end portion of the outermost battery cell 11. Heat transfer between the third node n3 and the second node n2 may be interpreted as heat transfer between two different solid bodies. That is, the two solid bodies may be the lower end portion of the outermost battery cell 11 and the virtual solid body indicating the temperature of the cooling water. The first node n1, the second node n2, and the third node n3 may be expressed in the form of an electrical RC circuit.

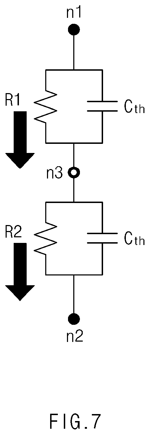

FIG. 7 illustrates an RC heat transfer model according to an embodiment of the present disclosure.

Cth described above may correspond to a concentrated heat capacity of the lower end portion of the outermost battery cell 11, such that Cth may be equal in two capacitors. On the other hand, R1 and R2 may be different from each other because a thermal conductive resistance is determined by characteristics of two virtual solid bodies

$$C_{th} = \rho V_c, R1 = \frac{1}{k1A1/L1}, R2 = \frac{1}{k2A2/L2}.$$

To calculate a temperature in real time by the BMS 20, a differential form with respect to time in [Equation 8] needs to be used, resulting in [Equation 10].

[Equation 10]

$$\frac{dT}{dt} = \frac{1}{\tau_{th}}(T_\infty - T_i)\exp\left(-{}^{t}/_{\tau_{th}}\right)$$

A heat transfer path has been simplified, such that a difference may occur between a theoretical value and an actual value of $\tau_{th}$. Therefore, additional correction may be required using the heat-dissipation/cooling condition test results of the battery, etc. To minimize such correction factors, it is necessary to perform modeling without missing a heat transfer key path that dominates a temperature change while simplifying the heat transfer key path.

An equation corrected finally may be as shown in [Equation 11].

[Equation 11]

$$\frac{dT}{dt} = \frac{1}{\tau_{eff}}(T_\infty - T_i)\exp\left(-{}^{t}/_{\tau_{teff}}\right), \tau_{teff} = \alpha\tau_{th}$$

By applying the battery module 10 to a 2 RC model simplified as shown in FIG. 7 by using Equation 11, the 2 RC model may be expressed as [Equation 12]. Meanwhile, in a heat transfer model of a virtual model, the solid temperature is assumed to be constant, but in reality, a temperature at the first position and a temperature at the second position may change over time. However, by reducing Δt, two temperatures may be regarded constant in a minute time difference.

[Equation 12]

$$\Delta T_n = 1/T_{eff1}(T_{n1} - T_{n-1})\exp\left(-\Delta t/T_{eff1}\right) + 1/T_{eff2}(T_{n2} - T_{n-1})\exp\left(-\Delta t/T_{eff2}\right)$$

$T_{n1}$ and $T_{n2}$ may indicate the temperatures at the first position and the second position, respectively.

The temperature of the outermost cell of battery cell 11 to be obtained may be as below.

[Equation 13]

$$T_n = T_{n-1} + \Delta T_n$$

As a result, it may be seen that this equation is a function regarding two temperature values $T_{n1}$, $T_{n2}$, and $T_{n-1}$ (an outermost cell temperature calculated in the previous step) measured using the first temperature sensor and the second temperature sensor.

[Equation 14]

$$T_n = f(T_{n1}, T_{n2}, T_{n-1})$$

The minimum temperature may be calculated in the battery module 10 based on such an RC model. In addition, an average temperature may be calculated based on the calculated minimum temperature. For example, the average temperature calculating unit 252 may calculate the average temperature as below.

[Equation 15]

$$\mathrm{Tcell\_avg = (Tcell\_min + Tcell\_max)/2}$$

$T_{cell\_max}$ may be a temperature value measured by the first temperature sensor provided in the first position. In addition, in the equation of the RC model derived above, $T_{cell\_max}$ may correspond to $T_{n1}$. $T_{cell\_min}$ may be a temperature of the third position. In addition, in the equation of the RC model derived above, $T_{cell\_min}$ may correspond to $T_n$.

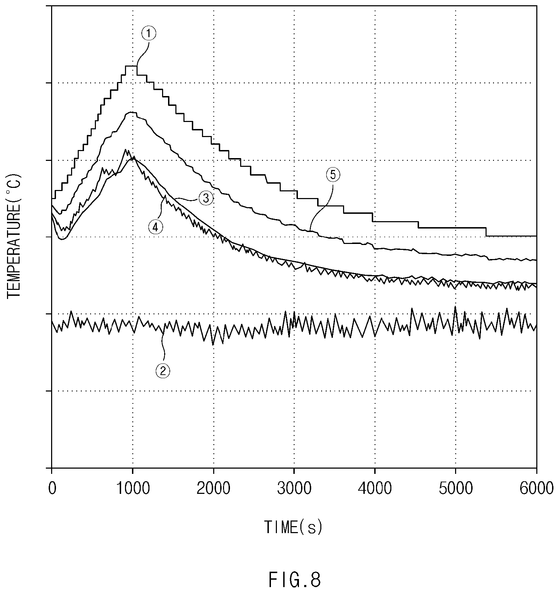

FIG. 8 illustrates parameters used by a method of calculating an aging degree, according to an embodiment of the present disclosure.

① indicates a temperature value of the first temperature sensor, which is the maximum temperature, ② indicates a temperature value of the second temperature sensor, which is the temperature of the cooling means, ③ indicates the minimum temperature value of the battery module 10 estimated by the RC model, and ④ indicates the minimum temperature value (a true value of the minimum temperature value) of the battery module 10, and ⑤ indicates the average temperature value.

Conventionally, by using the temperature value of the first temperature sensor, indicated by ①, the aging degree of the battery has been calculated. However, in embodiments of the present disclosure, ③ may be estimated using an RC model and the average temperature value indicated by ⑤ may be calculated using ③, after which the aging degree of the battery is calculated based on the calculated average temperature value.

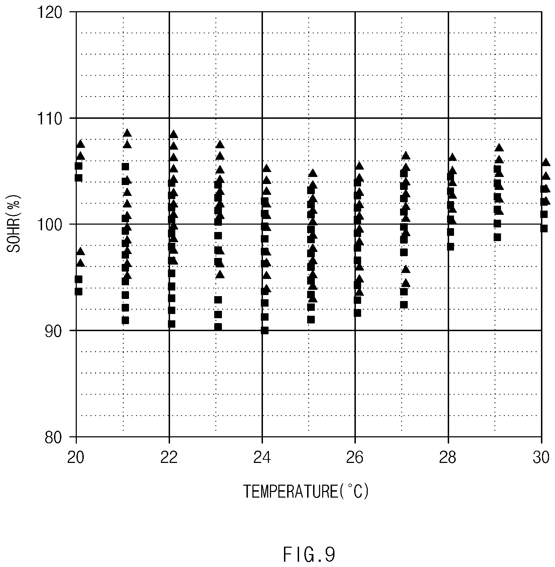

FIG. 9 illustrates an aging degree calculated according to an embodiment of the present disclosure.

The aging degree of the battery calculated according to the embodiments of the present disclosure may be indicated by a triangle. The aging degree of the battery calculated according to the conventional art may be indicated by a rectangle. When compared to the aging degree of the battery calculated according to the conventional art, the aging degree of the battery calculated according to embodiments of the present disclosure has a low error rate.

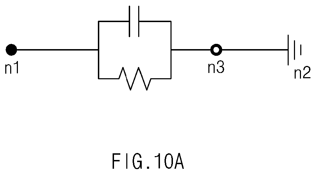

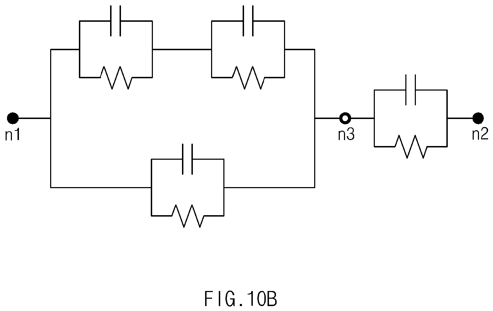

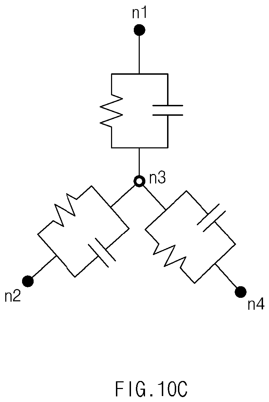

FIGS. 10A through 10C illustrate various modified examples of an RC model according to the present disclosure.

As shown in FIGS. 7 and 10A through 10C, when the state of the battery is the second state, the minimum temperature value of the battery may be calculated based on a heat transfer model among the first position of the first temperature sensor mounted on the battery, the second position of the second temperature sensor mounted on the cooling means of the battery, and the third position of the battery where the battery and the cooling means contact each other. In this case, least one of a space between the first position and the third position and a space between the third position and the second position by using a RC model.

Although not shown, it may be understood that an appropriate number of temperature sensors may be added in appropriate positions to apply the model shown in FIGS. 10A through 10C. For example, a plurality of temperature sensors provided in a plurality of positions in the battery module 10 may be further used, and additionally/alternatively, a plurality of temperature sensors provided in a plurality of positions of the cooling means 400 may be used.

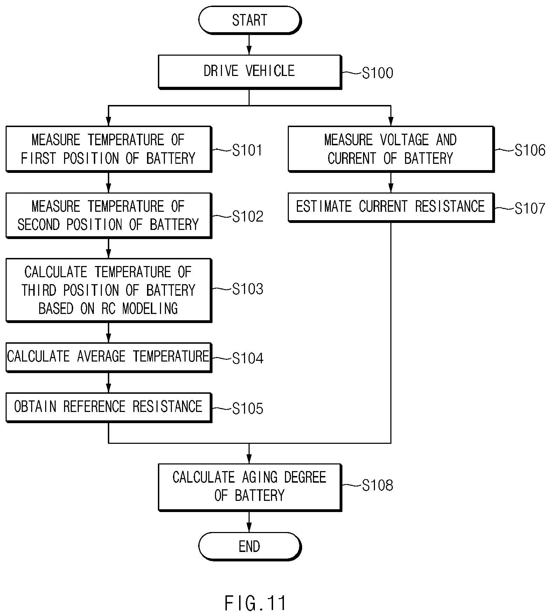

FIG. 11 is a flowchart illustrating a method of calculating an aging degree, according to an embodiment of the present disclosure.

Referring to FIG. 11, when an electric vehicle is used in operation S100, power for driving may be supplied from a battery to a vehicle. During driving of the vehicle, a temperature of a first position of the battery may be measured in operation S101. The first position may be a position where the temperature is expected to be maximum in the battery. A temperature of a second position of the battery may be measured in operation S102. The second position may be a position where the temperature is expected to be minimum in the battery. For example, the second position may be a part of the cooling means. The temperature of the third position of the battery may be calculated based on the temperature of the first position, the temperature of the second position, and RC modeling. The third position may be a position where the temperature is expected to be minimum among the battery cells 11 in the battery module 10. The third position may be a region where the battery module 10 is adjacent to the cooling means 400.

When the temperature of the third position is calculated, an average temperature may be calculated using the temperature of the first position and the temperature of the third position in operation S104, and obtain a reference internal resistance based on the calculated average temperature in operation S105.

Meanwhile, simultaneously with or before or after calculation of the average temperature, an operation of calculating a current internal resistance may be performed. To this end, a voltage and a current of the battery may be measured in operation S106. Then, by using the measured voltage value and current value, the current internal resistance of the battery may be estimated in operation S107.

In operation S108, an aging degree of the battery may be calculated based on the reference internal resistance obtained in operation S105 and the current internal resistance estimated in operation S107.

As such, the method of calculating the aging degree of the battery according to the present disclosure may calculate the minimum temperature of the battery by using an RC heat transfer model to calculate the average temperature of the battery, thereby accurately measuring the appropriate average temperature of the battery for calculating the aging degree. As a result, the accurate reference internal resistance of the battery may be obtained, thereby calculating the accurate aging degree of the battery.

In the above-described situation, i.e., when the state of the battery is the first state or the second state, that is, when there is no state change, the average temperature of the battery cell may be calculated through heat transfer analysis based on the RC model. On the other hand, when state change occurs like when the state of the battery is changed from the first state to the second state, initial temperature setting for calculating the average temperature needs to be different. Thus, in embodiments of the present disclosure, an initial average temperature may be calculated using at least two different algorithms as below.

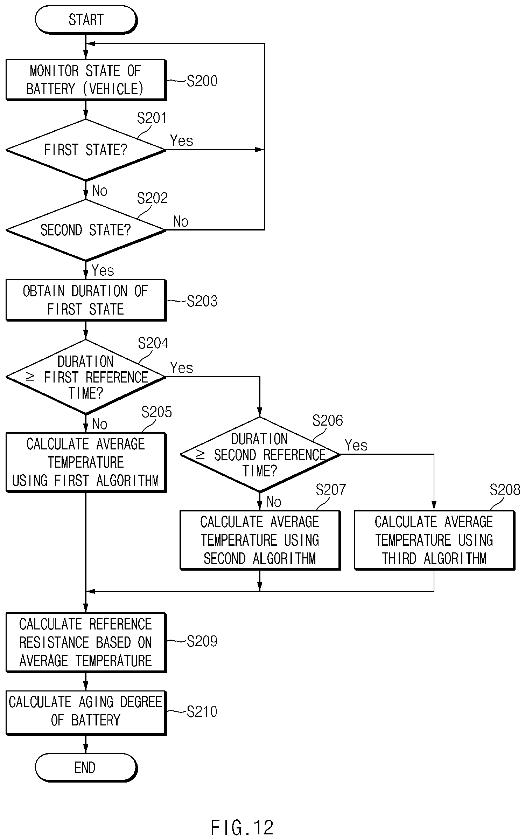

FIG. 12 is a flowchart illustrating a method of calculating an aging degree, according to another embodiment of the present disclosure.

Before FIG. 12 is described, the control unit 25 may perform an end process to be described below when a load such as a vehicle, etc., enters the first state. The end process may be performed when the vehicle enters a parking state. Alternatively, the end process may be performed when the output of the battery is less than the reference output.

The end process may store data regarding an initial minimum temperature value to be used when the vehicle is changed from the first state to the second state. In the end process, the following proportional factor may be calculated and stored in the storing unit 24.

[Equation 16]

$$k = (T_n - T_{n2})/(T_{n1} - T_{n2})$$

$T_n$ may indicate the temperature of the third position, that is, the minimum temperature value. $T_n$ may correspond to $T_{cell\_min}$ in FIG. 3. $T_{n1}$ may indicate the temperature of the first position, that is, the maximum temperature value. $T_{n1}$ may correspond to $T_{cell\_max}$ in FIG. 3. $T_{n2}$ may indicate the temperature of the second position. $T_{n2}$ may correspond to $T_{coolant}$ in FIG. 3.

The control unit 25 may store the calculated proportional coefficient and the minimum temperature value $T_n$ in the storing unit 24.

The proportional coefficient and the minimum temperature value may be stored as described above, and the control unit 25 may continue monitoring the state of the vehicle in operation S200. When the state of the vehicle is monitored, it may mean that the state of the battery is monitored. Alternatively, when the state of the vehicle is monitored, it may mean that a signal regarding the state of the vehicle is received from the upper-level controller 2. The control unit 25 may count a duration in which the first state is maintained, in operation S201. The control unit 25 may monitor whether the state is changed from the first state to another state, and when determining that the state is changed from the first state to another state (No in operation S201), the control unit 25 may determine whether the vehicle is changed to the second state, in operation S202. When the control unit 25 determines that the vehicle is changed to the second state (Yes IN operation S202), the control unit 25 obtains a duration in which the battery is maintained in the first state, in operation S203.

The control unit 25 may determine whether the obtained duration is greater than or equal to the first reference time in operation S204. The reference time may be, for example, 30 minutes. However, this is merely an example, and the reference time may be a random proper time such as 1 minute, 5 minutes, 10 minutes, 30 minutes, 1 hour, etc.

When the duration is less than the first reference time, the control unit 25 may calculate the average temperature by using the first algorithm. The first algorithm may calculate the average temperature value of the battery by using the minimum temperature of the battery calculated before start of the first state of the battery and a temperature measurement value of the temperature sensor mounted on the battery. That is, in the first algorithm, the minimum temperature value of the battery, calculated and stored before start of the first state, is used.

When the duration is greater than or equal to the first reference time, the control unit 25 may calculate the average temperature by using the second algorithm in operation S207. The second algorithm may calculate the minimum tempeature value of the battery based on the temperature measurement value of the first temperature sensor and the temperature measurement value of the second temperature sensor mounted on the cooling means of the battery. In this case, the minimum temperature value may be calculated using the proportional coefficient calculated and stored before the battery starts the first state. For example, based on calculation such as $T_n = T_{n2} + k(T_{n1} - T_{n2})$, the minimum temperature value may be calculated. Thereafter, in the second algorithm, the average temperature of the battery may be calculated using the temperature measurement value of the first temperature sensor and the calculated minimum temperature value.

As an additional embodiment, as shown in operation S206 of FIG. 12, when the duration is determined to be greater than or equal to the first reference time, it may be further determined whether the duration is greater than nor equal to the second reference time. The second reference time may be longer than the first reference time. When the duration is determined to be greater than or equal to the second reference time in operation S206, the average temperature may be calculated using the third algorithm instead of the second algorithm, in operation S208. The third algorithm may use a temperature measurement value of the first temperature sensor mounted on the battery, as the average temperature. For example, when the vehicle is maintained in the parking state for a long time, the maximum temperature value of the battery, the minimum temperature value of the battery, and the temperature value of the cooling means may be actually equal to each other. Thus, when the time in which the first state is maintained is longer than the second reference time, the maximum temperature value may be used as the average temperature.

When the average temperature is calculated by any one of the first through third algorithms, the reference internal resistance may be calculated in the same manner as described above based on the calculated average temperature in operation S209. Then, by using the calculated reference internal resistance and current internal resistance, the aging degree of the battery may be calculated in operation S210.

As such, in calculating the average temperature of the battery as described above, the method and apparatus for calculating the aging degree of the battery according to the present disclosure, when the state of the battery is changed from the first state to the second state, according to the duration in the first state, a different algorithm for calculating the average temperature of the battery may be used, thereby accurately calculating the average temperature of the battery. Therefore, the accurate aging degree of the battery may be calculated.

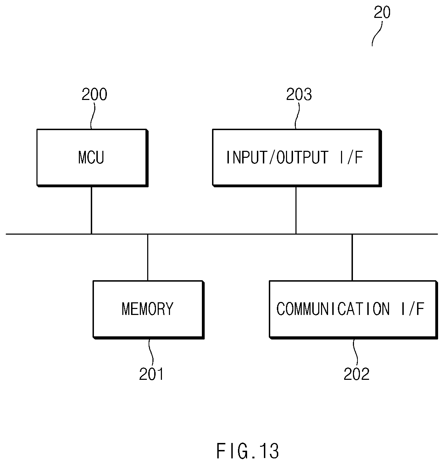

FIG. 13 shows a hardware configuration of the BMS 20 according to embodiments of the present disclosure.

Referring to FIG. 13, the BMS 20 may include a controller (micro control unit (MCU)) 200, a memory 201, a communication interface 202, and an input/output 203.

The MCU 200 may process various operations and calculations in the BMS 20 and control each component.

In the memory 201, an operating system program and a program for performing a function of the MCU 200 may be recorded. The memory 201 may include a volatile memory and a nonvolatile memory. For example, at least one of various storage media such as a semiconductor memory like random-access memory (RAM), read-only memory (ROM), flash memory, etc., and a magnetic disk, an optical disk, etc., may be used as the memory 201. The memory 201 may be a memory embedded in the MCU 200 or an additional memory installed separately from the MCU 200.

The communication I/F 202 may be a component that is capable of wiredly and/or wirelessly communicating with an outside.

The input/output I/F 203 may perform inputting/outputting of various input signals and output signals.

As the MCU 200 executes a program stored in the memory 201, the MCU 200 may perform a function of each component included in the control unit 25 of the BMS 20. In addition, the MCU 200 may function as the voltage measuring unit 21, the current measuring unit 22, and the temperature measuring unit 23, based on a program stored in the memory 201 and various measurement signals received through the input/output I/F 203.

The memory 201 may function as the storing unit 24. The MCU 200 may function as a communication means communicating with the upper-level controller 2 by operating together with the communication I/F 202.

Terms such as "include", "constitute" or "have" described above may mean that the corresponding component may be inherent unless otherwise stated, and thus should be construed as further including other components rather than excluding other components. All terms including technical or scientific terms may be interpreted as having the same meanings as those generally understood by those of ordinary skill in the art unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present disclosure.

**Claims**

1. A method of calculating an aging degree of a battery (10), the method comprising:

   obtaining (S203) a duration of the battery (10) in a first state, when a use state of the battery (10) is changed from the first state to a second state;
   determining (S204) whether the obtained duration is greater than or equal to a first reference time;

calculating (S205) an average temperature of the battery (10) based on a first algorithm when the duration is less than the first reference time, and calculating the average temperature of the battery based on a second algorithm when the duration is greater than or equal to a reference time ; and

calculating (S210) the aging degree of the battery (10) based on the calculated average temperature.

2. The method of claim 1, wherein the first algorithm calculates (S205) the average temperature of the battery (10) by using a minimum temperature value of the battery (10) calculated before start of the first state of the battery (10) and a temperature measurement value of a temperature sensor mounted on the battery (10) .

3. The method of claim 1, wherein the second algorithm calculates the minimum temperature value of the battery (10) based on a temperature measurement value of a first temperature sensor mounted on the battery (10) and a temperature measurement value of a second temperature sensor mounted on a cooling means of the battery, and calculates (S207) the average temperature of the battery (!0) using the temperature measurement value of the first temperature sensor and the calculated minimum temperature value.

4. The method of claim 3, wherein the second algorithm calculates the minimum temperature value using a value indicating a relationship between a maximum temperature value and the minimum temperature value of the battery (10), the maximum temperature value and the minimum temperature value being calculated and stored before the start of the first state of the battery (10).

5. The method of claim 3, wherein the first temperature sensor comprises a sensor arranged in a maximum-temperature region of the battery (10).

6. The method of claim 3, wherein the minimum temperature value of the battery (10) comprises a temperature value of a region where the battery (!0) is adjacent to the cooling means.

7. The method of claim 1, wherein the first algorithm and the second algorithm are used for initial value setting when the state of the battery (10) is changed to the second state.

8. The method of claim 1, wherein when the state of the battery (10) is the second state, the minimum temperature value of the battery (10) is calculated based on a heat transfer model among a first position of a first temperature sensor mounted on the battery (10), a second position of a second temperature sensor mounted on the cooling means of the battery (10), and a third position of the battery (10) where the battery and the cooling means contact each other.

9. The method of claim 8, wherein the heat transfer model models at least one of a space between the first position and the third position and a space between the third position and the second position by using an RC model.

10. The method of claim 1, wherein when the duration is a second reference time longer than the first reference time, an average temperature is calculated by the third algorithm in place of the second algorithm, and the third algorithm uses the temperature measurement value of a first temperature sensor mounted on the battery, as the average temperature.

11. The method of claim 1, wherein the first state comprises a parking state of an electric vehicle, and the second state comprises a driving state of the electric vehicle.

12. The method of claim 1, wherein the first state comprises a state in which the battery (10) is used as an output less than a reference output, and the second state comprises a state in which the battery (10) is used as an output greater than or equal to the reference output.

13. An apparatus (20) for calculating an aging degree of a battery (10), the apparatus comprising:

a time comparing unit (251) configured to determine whether a duration of a first state is greater than or equal to a first reference time, when a use state of the battery (10) is changed from the first state to a second state;

an average temperature calculating unit (252) configured to calculate an average temperature of the battery (10) based on a first algorithm when the duration is less than the first reference time, and calculating the average temperature of the battery (10) based on a second algorithm when the duration is greater than or equal to a reference time ; and

an aging degree calculating unit (253) configured to calculate the aging degree of the battery based on the calculated average temperature.

**14.** The apparatus (20) of claim 13, wherein the first algorithm calculates the average temperature of the battery (10) by using a minimum temperature value of the battery (10) calculated before start of the first state of the battery (10) and a temperature measurement value of a temperature sensor mounted on the battery (10).

**15.** The apparatus (20) of claim 13, wherein the second algorithm calculates the minimum temperature value of the battery (10) based on a temperature measurement value of a first temperature sensor mounted on the battery (10) and a temperature measurement value of a second temperature sensor mounted on a cooling means of the battery (10), and calculates the average temperature of the battery (10) using the temperature measurement value of the first temperature sensor and the calculated minimum temperature value.

**Patentansprüche**

**1.** Verfahren zum Berechnen eines Alterungsgrads einer Batterie (10), wobei das Verfahren umfasst:

Erhalten (S203) einer Dauer der Batterie (10) in einem ersten Zustand, wenn ein Nutzungszustand der Batterie (10) von dem ersten Zustand zu einem zweiten Zustand geändert wird;
Bestimmen (S204), ob die erhaltene Dauer gleich oder größer einer ersten Referenzzeit ist;
Berechnen (S205) einer Durchschnittstemperatur der Batterie (10) auf Grundlage eines ersten Algorithmus, wenn die Dauer weniger als die erste Referenzzeit ist, und Berechnen der Durchschnittstemperatur der Batterie auf Grundlage eines zweiten Algorithmus, wenn die Dauer gleich oder größer einer Referenzzeit ist, und Berechnen (S210) des Alterungsgrads der Batterie (10) auf Grundlage der berechneten Durchschnittstemperatur.

**2.** Verfahren nach Anspruch 1, wobei der erste Algorithmus die Durchschnittstemperatur der Batterie (10) unter Verwendung eines minimalen Temperaturwertes der Batterie (10), welcher vor dem Start des ersten Zustands der Batterie (10) berechnet wird, und eines Temperaturmessungswertes eines Temperatursensors berechnet (S205), welcher an der Batterie (10) angebracht ist.

**3.** Verfahren nach Anspruch 1, wobei der zweite Algorithmus den minimalen Temperaturwert der Batterie (10) auf Grundlage eines Temperaturmessungswertes eines ersten Temperatursensors, welcher an der Batterie (10) angebracht ist, und eines Temperaturmessungswertes eines zweiten Temperatursensors berechnet, welcher an einem Kühlungsmittel der Batterie angebracht ist, und die Durchschnittstemperatur der Batterie (10) unter Verwendung des Temperaturmessungswertes des ersten Temperatursensors und des berechneten minimalen Temperaturwertes berechnet (S207).

**4.** Verfahren nach Anspruch 3, wobei der zweite Algorithmus den minimalen Temperaturwert unter Verwendung eines Wertes berechnet, welcher eine Beziehung zwischen einem maximalen Temperaturwert und dem minimalen Temperaturwert der Batterie (10) angibt, wobei der maximale Temperaturwert und der minimale Temperaturwert vor dem Start des ersten Zustands der Batterie (10) berechnet und gespeichert werden.

**5.** Verfahren nach Anspruch 3, wobei der erste Temperatursensor einen Sensor umfasst, welcher in einem Maximaltemperaturbereich der Batterie (10) angeordnet ist.

**6.** Verfahren nach Anspruch 3, wobei der minimale Temperaturwert der Batterie (10) einen Temperaturwert eines Bereichs umfasst, in welchem die Batterie (10) dem Kühlungsmittel benachbart ist.

**7.** Verfahren nach Anspruch 1, wobei der erste Algorithmus und der zweite Algorithmus für eine Initialwerteinstellung verwendet werden, wenn der Zustand der Batterie (10) zu dem zweiten Zustand geändert wird.

**8.** Verfahren nach Anspruch 1, wobei, wenn der Zustand der Batterie (10) der zweite Zustand ist, der minimale Temperaturwert der Batterie (10) auf Grundlage eines Wärmetransfermodells berechnet wird, unter einer ersten Position eines ersten Temperatursensors, welcher an der Batterie (10) angebracht wird, einer zweiten Position eines zweiten Temperatursensors, welcher an dem Kühlungsmittel der Batterie (10) angebracht wird, und einer dritten Position der Batterie (10), an welcher die Batterie und das Kühlungsmittel in Kontakt miteinander stehen.

**9.** Verfahren nach Anspruch 8, wobei das Wärmetransfermodell wenigstens einen aus einem Raum zwischen der ersten Position und der dritten Position und einem Raum zwischen der dritten Position und der zweiten Position unter Verwendung eines RC-Modells modelliert.

**10.** Verfahren nach Anspruch 1, wobei, wenn die Dauer eine zweite Referenzzeit länger als die erste Referenzzeit ist, eine Durchschnittstemperatur durch den dritten Algorithmus anstelle des zweiten Algorithmus berechnet wird und der dritte Algorithmus den Temperaturmessungswert eines ersten Temperatursensors, welcher an der Batterie angebracht ist, als die Durchschnittstemperatur verwendet.

**11.** Verfahren nach Anspruch 1, wobei der erste Zustand einen Parkzustand eines elektrischen Fahrzeugs umfasst und der zweite Zustand einen Fahrzustand des elektrischen Fahrzeugs umfasst.

**12.** Verfahren nach Anspruch 1, wobei der erste Zustand einen Zustand umfasst, in welchem die Batterie (10) als eine Ausgabe verwendet wird, welche geringer als eine Referenzausgabe ist, und der zweite Zustand einen Zustand umfasst, in welchem die Batterie (10) als eine Ausgabe verwendet wird, welche gleich oder größer der Referenzausgabe ist.

**13.** Vorrichtung (20) zum Berechnen eines Alterungsgrads einer Batterie (10), wobei die Vorrichtung umfasst:

eine Zeitvergleichseinheit (251), welche dazu eingerichtet ist, zu bestimmen, ob eine Dauer eines ersten Zustands gleich oder größer einer ersten Referenzzeit ist, wenn ein Nutzungszustand der Batterie (10) von dem ersten Zustand zu einem zweiten Zustand geändert ist;
eine Durchschnittstemperatur-Berechnungseinheit (252), welche dazu eingerichtet ist, eine Durchschnittstemperatur der Batterie (10) auf Grundlage eines ersten Algorithmus zu berechnen, wenn die Dauer weniger als die erste Referenzzeit ist, und die Durchschnittstemperatur der Batterie (10) auf Grundlage eines zweiten Algorithmus zu berechnen, wenn die Dauer gleich oder größer einer Referenzzeit ist; und
eine Alterungsgrad-Berechnungseinheit (253), welche dazu eingerichtet ist, den Alterungsgrad der Batterie auf Grundlage der berechneten Durchschnittstemperatur zu berechnen.

**14.** Vorrichtung (20) nach Anspruch 13, wobei der erste Algorithmus die Durchschnittstemperatur der Batterie (10) unter Verwendung eines minimalen Temperaturwertes der Batterie (10), welcher vor dem Start des ersten Zustands der Batterie (10) berechnet ist, und eines Temperaturmessungswertes eines Temperatursensors berechnet, welcher an der Batterie (10) angebracht ist.

**15.** Vorrichtung (20) nach Anspruch 13, wobei der zweite Algorithmus den minimalen Temperaturwert der Batterie (10) auf Grundlage eines Temperaturmessungswertes eines ersten Temperatursensors, welcher an der Batterie (10) angebracht ist, und eines Temperaturmessungswertes eines zweiten Temperatursensors berechnet, welcher an einem Kühlungsmittel der Batterie (10) angebracht ist, und die Durchschnittstemperatur der Batterie (10) unter Verwendung des Temperaturmessungswertes des ersten Temperatursensors und des berechneten minimalen Temperaturwertes berechnet.

**Revendications**

**1.** Procédé de calcul d'un degré de dégradation d'une batterie (10), le procédé comprenant :

l'obtention (S203) d'une autonomie de la batterie (10) dans un premier état, lorsqu'un état d'utilisation de la batterie (10) passe du premier état à un second état ;
la détermination (S204) pour établir si l'autonomie obtenue est supérieure ou égale à un premier temps de référence ;
le calcul (S205) d'une température moyenne de la batterie (10) sur la base d'un premier algorithme lorsque l'autonomie est inférieure au premier temps de référence, et le calcul de la température moyenne de la batterie sur la base d'un deuxième algorithme lorsque l'autonomie est supérieure ou égale à un temps de référence ; et
le calcul (S210) du degré de dégradation de la batterie (10) sur la base de la température moyenne calculée.

**2.** Procédé selon la revendication 1, dans lequel le premier algorithme calcule (S205) la température moyenne de la batterie (10) en utilisant une valeur de température minimale de la batterie (10) calculée avant le début du premier état de la batterie (10) et une valeur de mesure de température d'un capteur de température monté sur la batterie (10).

**3.** Procédé selon la revendication 1, dans lequel le deuxième algorithme calcule la valeur de température minimale de la batterie (10) sur la base d'une valeur de mesure de température d'un premier capteur de température monté sur la batterie (10) et d'une valeur de mesure de température d'un second capteur de température monté sur un moyen de refroidissement de la batterie, et calcule (S207) la température moyenne de la batterie (10) à l'aide de la valeur de mesure de température du premier capteur de température et de la valeur de température minimale calculée.

**4.** Procédé selon la revendication 3, dans lequel le deuxième algorithme calcule la valeur de température minimale à l'aide d'une valeur indiquant une relation entre une valeur de température maximale et la valeur de température minimale de la batterie (10), la valeur de température maximale et la valeur de température minimale étant calculées et stockées avant le début du premier état de la batterie (10).

**5.** Procédé selon la revendication 3, dans lequel le premier capteur de température comprend un capteur agencé dans une région de température maximale de la batterie (10).

**6.** Procédé selon la revendication 3, dans lequel la valeur de température minimale de la batterie (10) comprend une valeur de température d'une région où la batterie (10) est adjacente au moyen de refroidissement.

**7.** Procédé selon la revendication 1, dans lequel le premier algorithme et le deuxième algorithme sont utilisés pour le réglage de valeur initiale lorsque l'état de la batterie (10) passe au second état.

**8.** Procédé selon la revendication 1, dans lequel, lorsque l'état de la batterie (10) est le second état, la valeur de température minimale de la batterie (10) est calculée sur la base d'un modèle de transfert de chaleur parmi une première position d'un premier capteur de température monté sur la batterie (10), une deuxième position d'un second capteur de température monté sur le moyen de refroidissement de la batterie (10) et une troisième position de la batterie (10) où la batterie et le moyen de refroidissement sont en contact l'un avec l'autre.

**9.** Procédé selon la revendication 8, dans lequel le modèle de transfert de chaleur modélise au moins l'un d'un espace entre la première position et la troisième position et d'un espace entre la troisième position et la deuxième position en utilisant un modèle RC.

**10.** Procédé selon la revendication 1, dans lequel, lorsque l'autonomie est un second temps de référence plus long que le premier temps de référence, une température moyenne est calculée par le troisième algorithme à la place du deuxième algorithme, et le troisième algorithme utilise la valeur de mesure de température d'un premier capteur de température monté sur la batterie, en tant que température moyenne.

**11.** Procédé selon la revendication 1, dans lequel le premier état comprend un état de stationnement d'un véhicule électrique, et le second état comprend un état de conduite du véhicule électrique.

**12.** Procédé selon la revendication 1, dans lequel le premier état comprend un état dans lequel la batterie (10) est utilisée comme sortie inférieure à une sortie de référence, et le second état comprend un état dans lequel la batterie (10) est utilisée comme sortie supérieure ou égale à la sortie de référence.

**13.** Appareil (20) de calcul d'un degré de dégradation d'une batterie (10), l'appareil comprenant :

une unité de comparaison de temps (251) configurée pour déterminer si une autonomie d'un premier état est supérieure ou égale à un premier temps de référence, lorsqu'un état d'utilisation de la batterie (10) passe du premier état à un second état ;
une unité de calcul de température moyenne (252) configurée pour calculer une température moyenne de la batterie (10) sur la base d'un premier algorithme lorsque l'autonomie est inférieure au premier temps de référence, et calculer la température moyenne de la batterie (10) sur la base d'un deuxième algorithme lorsque l'autonomie est supérieure ou égale à un temps de référence ; et
une unité de calcul de degré de dégradation (253) configurée pour calculer le degré de dégradation de la batterie sur la base de la température moyenne calculée.

**14.** Appareil (20) selon la revendication 13, dans lequel le premier algorithme calcule la température moyenne de la batterie (10) en utilisant une valeur de température minimale de la batterie (10) calculée avant le début du premier état de la batterie (10) et une valeur de mesure de température d'un capteur de température monté sur la batterie (10).

**15.** Appareil (20) selon la revendication 13, dans lequel le deuxième algorithme calcule la valeur de température minimale de la batterie (10) sur la base d'une valeur de mesure de température d'un premier capteur de température monté sur la batterie (10) et d'une valeur de mesure de température d'un second capteur de température monté sur un moyen de refroidissement de la batterie (10), et calcule la température moyenne de la batterie (10) à l'aide de la valeur de mesure de température du premier capteur de température et de la valeur de température minimale calculée.

FIG.1

20

| VOLTAGE MEASURING UNIT | CURRENT MEASURING UNIT |
|---|---|

21

22

| TEMPERATURE MEASURING UNIT | STORING UNIT |
|---|---|

23

24

25

CONTROL UNIT

RESISTANCE CALCULATING UNIT — 250

TIME COMPARING UNIT — 251

AVERAGE TEMPERATURE CALCULATING UNIT — 252

AGING DEGREE CALCULATING UNIT — 253

FIG.2

250

Current[A]

Average Cell Voltage[V]

Average OCV[V]

RESISTANCE
CALCULATING
UNIT

25

253

$R_{cal}[\Omega]$

AGING DEGREE
CALCULATING
UNIT

252

$T_{cell\_max}[C°]$

$T_{coolant}[C°]$

$T_{cell\_min}[C°]$

AVERAGE
TEMPERATURE
CALCULATING
UNIT

$T_{cell\_avg}[C°]$

$T_{cell\_avg}[C°]$

$R_{ref}[\Omega]$

REFERENCE
RESISTANCE
TABLE

240

FIG.3

FIG.4

FIG.5

FIG.6

FIG.7

FIG.8

FIG.9

FIG.10A

FIG.10B

FIG.10C

START

DRIVE VEHICLE ~S100

MEASURE TEMPERATURE OF
FIRST POSITION OF BATTERY ~S101

MEASURE VOLTAGE AND
CURRENT OF BATTERY ~S106

MEASURE TEMPERATURE OF
SECOND POSITION OF BATTERY ~S102

ESTIMATE CURRENT RESISTANCE ~S107

CALCULATE TEMPERATURE OF
THIRD POSITION OF BATTERY
BASED ON RC MODELING ~S103

CALCULATE AVERAGE TEMPERATURE ~S104

OBTAIN REFERENCE RESISTANCE ~S105

CALCULATE AGING DEGREE
OF BATTERY ~S108

END

F I G . 11

FIG.12

20

200

203

MCU

INPUT/OUTPUT I/F

MEMORY

COMMUNICATION I/F

201

202

FIG.13

**REFERENCES CITED IN THE DESCRIPTION**

**Patent documents cited in the description**

- KR 1020200130580
- US 2016377686 A1